Europäisches Patentamt

European Patent Office

Office européen des brevets

(11) Veröffentlichungsnummer: **0 382 038**
**A1**

(12) **EUROPÄISCHE PATENTANMELDUNG**

(21) Anmeldenummer: **90101712.9**

(22) Anmeldetag: **29.01.90**

(51) Int. Cl.⁵: **H01R 9/09, H05K 3/34**

(30) Priorität: **08.02.89 DE 8901434 U**

(43) Veröffentlichungstag der Anmeldung:
**16.08.90 Patentblatt 90/33**

(84) Benannte Vertragsstaaten:
**DE ES FR GB IT NL**

(71) Anmelder: **Grote & Hartmann GmbH & Co. KG**
**Am Kraftwerk 13**
**D-5600 Wuppertal 21(DE)**

(72) Erfinder: **Zinn, Bernd**
**Peter-Alfs-Strasse 6**
**D-5828 Ennepetal(DE)**
Erfinder: **Hiby, Ulrike**
**Hiddinghauser Strasse 13**
**D-4322 Sprockhövel(DE)**

(74) Vertreter: **Patentanwälte Dr. Solf & Zapf**
**Schlossbleiche 20 Postfach 13 01 13**
**D-5600 Wuppertal 1(DE)**

(54) **Kontaktierungsvorrichtung für eine Leuchtdiode.**

(57) Kontaktierungsvorrichtung für eine Leuchtdiode oder dergleichen elektrische Elemente mit dünnen, biegsamen Kontaktelementen, die durch Löcher einer Leiterplatte zu stecken und mit elektrischen Kontakten auf der Leiterplatte durch Lötung zu kontaktieren sind, **dadurch gekennzeichnet**, daß sie eine aus einem Blechstanzteil geformte Lötkontaktfeder (1) aufweist, die mit mit den Kontaktelementen der Leiterplatte verlötbaren Lötbeinen ausgerüstet ist und Kontaktfederarme (11) zur elektrischen Kontaktierung der biegsamen Kontaktelemente (25, 27) z. B. einer Leuchtdiode aufweist.

FIG. 5

EP 0 382 038 A1

## Kontaktierungsvorrichtung für eine Leuchtdiode

Die Erfindung betrifft eine Kontaktierungsvorrichtung für eine Leuchtdiode oder dergleichen elektrische Elemente.

Leuchtdioden weisen in der Regel einen Diodenkörper und zwei aus dem Diodenkörper geführte Kontaktdrähte aus Metall auf. Die Kontaktierung mit einer Leiterplatte erfolgt derzeit, indem die Kontaktdrähte durch Löcher in der Leiterplatte gesteckt und die herausragenden Endstücke der Kontaktdrähte mit Kontaktelementen der Leiterplatte verlötet werden. Da die Kontaktdrähte sehr weich und dünn sind, bereitet dieses Verfahren Schwierigkeiten. Außerdem können mehrere Leuchtdioden nur zeitlich nacheinander verlötet werden, was einen hohen Zeitaufwand erfordert. Vielfach ist der elektrische Kontakt der Lötstelle schadhaft.

Aufgabe der Erfindung ist, eine Kontaktierungsvorrichtung für eine Leuchtdiode mit einer Leiterplatte zu schaffen, die einfach und schnell zu bewerkstelligen ist und die eine sichere Kontaktierung gewährleistet. Diese Aufgabe wird durch die Merkmale des Anspruches 1 gelöst. Vorteilhafte Weiterbildungen der Erfindung werden in den Unteransprüchen gekennzeichnet.

Anhand der Zeichnungen wird die Erfindung im folgenden beispielhaft näher erläutert. Es zeigen:
Fig. 1 eine perspektivische Abbildung der Lötkontaktfeder,
Fig. 2 eine Seitenansicht der Lötkontaktfeder,
Fig. 3 eine Draufsicht auf die Lötkontaktfeder,
Fig. 4 einen Querschnitt durch die Lötkontaktfeder,
Fig. 5 die Kontaktierung einer Leuchtdiode.

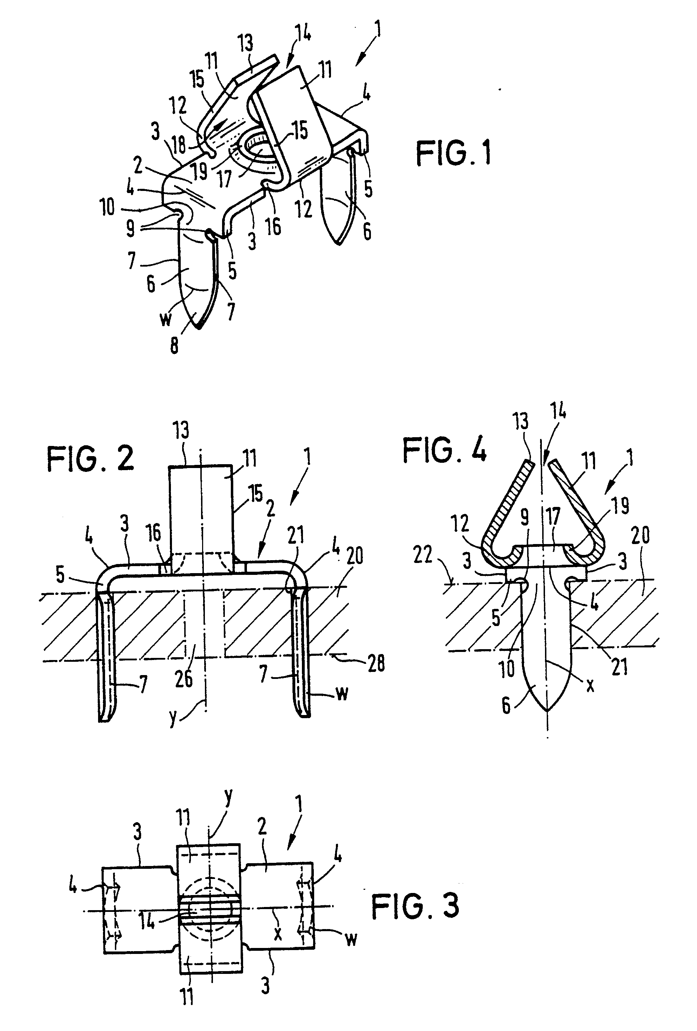

Die in den Figuren 1 bis 4 im Maßstab von etwa 10:1 abgebildete Lötkontaktfeder 1 aus einem Blechstanzteil in Miniaturbauweise ist symmetrisch zu dem Ebenen X und Y ausgebildet und weist eine rechteckige Basisplatte 2 mit zwei Längskanten 3 und zwei Querkanten 4 auf. An die Querkanten 4 ist jeweils übergangslos ein rechtwinkelig nach unten abgebogener kurzer Steg 5 angebunden, der in ein Lötbein 6 übergeht. Das Lötbein 6 ist in der Quermitte des Stützstegs 5 angeordnet und etwa halb so breit ausgebildet wie die Breite des Stützstegs 5 bzw. der Querkante 4 beträgt. Das Lötbein 6 weist die Längskanten 7 und einen rundspitzbogenförmigen Endbereich 8 auf. Im Übergangsbereich vom Stützsteg 5 zum Lötbein 6 ist jeweils eine kurze Ausnehmung, z. B. in Form eines runden, nach außen geöffneten Lochs 9, eingestanzt, so daß der Anbindungssteg 10 des Lötbeins 6 an den Stützsteg 5 schmaler ist als das Lötbein 6. Das Lötbein 6 ist quer zu seiner Längserstreckung rinnenförmig nach außen gewölbt, wobei die Wölbung W durch die bogenförmigen Linien in Fig. 1 angedeutet und in den Figuren 2 und 3 ohne weiteres erkennbar ist.

Die Formgebung der Wölbung W wird durch die Ausnehmungen 9 erleichtert.

An die Längskanten 3 der Basisplatte 2 ist im Bereich ihrer Längsmitte jeweils ein nach oben abgebogener, vorzugsweise rechteckiger Kontaktfederarm 11 angebunden, wobei im Übergangsbereich zwischen Kontaktfederarm 11 und Basisplatte 2 ein aus der Kante 3 seitlich vorspringendes Bogenstück 12 vorgesehen ist und die Kontaktfederarme 11 schräg aufeinander zulaufend abgebogen sind, so daß ihre Querkante 13 am freien Ende einen Steckkontaktschliz 14 bilden. Die Breite eines Kontaktfederarms 11 entspricht etwa einem Drittel der Länge einer Längskante 3. Die Länge eines Kontaktfederarms 11 ist etwa gleich der Länge eines Lötbeins 6. Im Übergangsbereich einer Längskante in die Längskante 15 eines Kontaktfederarms 11 ist eine runde Ausnehmung 16 vorgesehen, um die Formgebung des Kontaktfederarms zu erleichtern.

Unter dem Steckkontaktschlitz 14 ist in der Basisplatte 2 ein rundes Loch 17 ausgestanzt mit nach oben, d. h. zum Innenraum 18 zwischen den Kontaktfederarmen 11, geneigten kegelstumpfförmigen bzw. kraterförmigen Trichterrand 19. Der Durchmesser des Lochs 17 ist etwas kleiner als die Breite der Kontaktfederarme 11 beträgt.

Die neue Lötkontaktfeder 1 ist in eine Leiterplatte 20 steckbar (Figuren 2, 4). Für diesen Zweck weist die Leiterplatte 20 Steckschlitze 21 für die Lötbeine 6 auf. Die Steckschlitze 21 werden von den Lötbeinen 6 durch-griffen, so daß zumindest der Endbereich 8 der Lötbeine 6 nach unten herausragt. Durch die Wölbung W der Lötbeine 6 und die Abmessungen des Steckschlitzes 21 können die Lötbeine 6 mit Preßsitz in den Steckschlitzen 21 lagern, wobei sich die Wölbung W an der entsprechenden Wandung und die Längskanten 7 in den entsprechenden Ecken eines Schlitzes 21 abstützen. Die Einstecktiefe der Lötbeine 6 wird durch den Stützsteg 5 begrenzt, der auf die Oberfläche 22 der Leiterplatte 20 stößt (Fig. 4).

Unter dem Loch 17 befindet sich in der Leiterplatte 20 ein Loch 26 gleichen Durchmessers, dessen Funktion weiter unten erläutert wird.

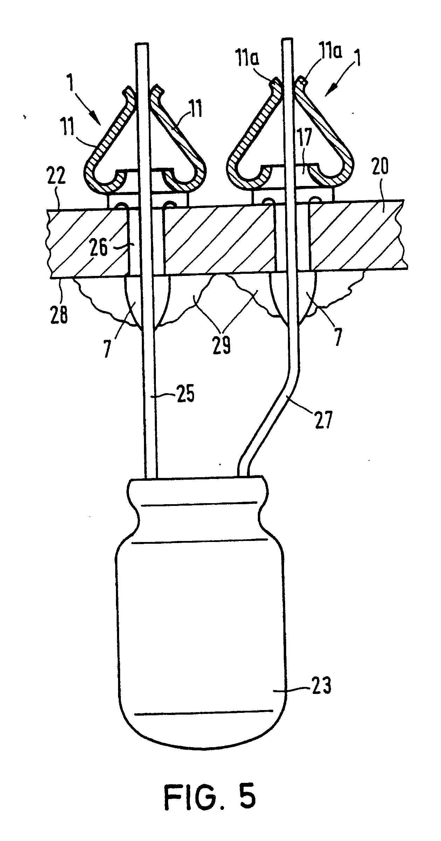

Nach einer besonderen in Fig. 5 abgebildeten Ausführungsform der Erfindung ist vorgesehen, die Endbereiche 11 a der Kontaktfederarme 11 nach außen divergierend abzubiegen und die Kontaktfederarme 11 derart aufeinanderzulaufend auszubilden, daß sie sich im Steckschlitzbereich berühren und eine Kontaktlinie bilden. Die divergierend abgebogenen Endbereiche 11 a können mit einem entsprechenden Werkzeug auseinandergebogen werden, so daß die kontaktierten Drähte und damit das kontaktierte Element entfernt werden können.

Fig. 5 zeigt die erfindungsgemäße Kontaktierungsvorrichtung mit einer Leuchtdiode 23, die einen Diodenkörper 24 und zwei Kontaktdrähte 25, 26 aufweist. Zur Herstellung der erfindungsgemäßen Kontaktierungsvorrichtung werden die die Unterfläche 28 überragenden Bereiche der Lötbeine 7 mehrerer Lötkontaktfedern 1 gleichzeitig mit Lot 29 verlötet, wobei die Löcher 26 in der Leiterplatte 20 freigehalten werden. Danach kann je ein Kontaktdraht 25, 27 von unten durch je ein Loch 26 der Leiterplatte 20 und je ein Loch 17 einer Lötkontaktfeder 1 sowie durch die Kontaktstelle der Federarme 11 der Lötkontaktfeder 1 gesteckt werden (Fig. 5). Die Kontaktdrähte 25, 27 werden durch die Federkraft der Federarme 11 ausreichend fest gehaltert, und die Federarme 11 gewährleisten einen sehr guten elektrischen Kontakt.

Die Vorbereitung der Kontaktierung und die Montage der Kontaktierung der Leuchtdiode ist sehr einfach und schnell und maschinell durchführbar. Dabei ist außerdem die Kontaktstelle sicher und gewährleistet einen definierten elektrischen Kontakt, was bisher z. B. aufgrund sogenannter "kalter Lötstellen" nicht gewährleistet werden konnte.

**Ansprüche**

1. Kontaktierungsvorrichtung für eine Leuchtdiode oder dergleichen elektrische Elemente mit dünnen, biegsamen Kontaktelementen, die durch Löcher einer Leiterplatte zu stecken und mit elektrischen Kontakten auf der Leiterplatte durch Lötung zu kontaktieren sind, **dadurch gekennzeichnet**, daß sie eine aus einem Blechstanzteil geformte Lötkontaktfeder (1) aufweist, die mit mit den Kontaktelementen der Leiterplatte verlötbaren Lötbeinen (6) ausgerüstet ist und Kontaktfederarme (11) zur elektrischen Kontaktierung der biegsamen Kontaktelemente (26,27) z. B. einer Leuchtdiode aufweist.

2. Kontaktierungsvorrichtung nach Anspruch 1, **dadurch gekennzeichnet**, daß die Lötkontaktfeder (1) symmetrisch zu zwei senkrecht aufeinanderstehenden Ebenen (X, Y) ausgebildet ist.

3. Kontaktierungsvorrichtung nach Anspruch 2, **dadurch gekennzeichnet**, daß sie eine rechteckige Basisplatte (2) aufweist, an deren Querkanten (4) jeweils ein Lötbein (6) rechtwinklig nach unten abgebogen angeordnet ist und an deren Längskanten (3) jeweils ein nach oben abgebogener Kontaktfederarm angebunden ist.

4. Kontaktierungsvorrichtung nach Anspruch 3, **dadurch gekennzeichnet**, daß jeweils zwischen einer Querkante (4) und einem Lötbein (6) ein rechtwinklig nach unten abgebogener kurzer Stützsteg (5) angeordnet ist.

5. Kontaktierungsvorrichtung nach Anspruch 4, **dadurch gekennzeichnet**, daß das Lötbein (6) in der Quermitte des Stützstegs (5) angeordnet und etwa halb so breit ausgebildet ist, wie die Breite des Stützstegs (5) bzw. der Querkante (4) beträgt.

6. Kontaktierungsvorrichtung nach einem oder mehreren der Ansprüche 1 bis 5, **dadurch gekennzeichnet**, daß das Lötbein (6) die Längskanten (7) und einen rundspitzbogenförmigen Endbereich (8) aufweist.

7. Kontaktierungsvorrichtung nach Anspruch 6, **dadurch gekennzeichnet**, daß im Übergangsbereich vom Stützsteg (5) zum Lötbein (6) jeweils eine kurze Ausnehmung eingestanzt ist.

8. Kontaktierungsvorrichtung nach Anspruch 7, **dadurch gekennzeichnet**, daß die Ausnehmung ein rundes, nach außen geöffnetes Loch (9) ist.

9. Kontaktierungsvorrichtung nach einem oder mehreren der Ansprüche 1 bis 8, **dadurch gekennzeichnet**, daß das Lötbein quer zu seiner Längserstreckung rinnenförmig nach außen gewölbt ausgebildet ist.

10. Kontaktierungsvorrichtung nach einem oder mehreren der Ansprüche 1 bis 9, **dadurch gekennzeichnet**, daß die Kontaktfederarme (11) rechteckig ausgebildet sind.

11. Kontaktierungsvorrichtung nach Anspruch 10, **dadurch gekennzeichnet**, daß die Kontaktfederarme in der Längsmitte der Längskanten (3) der Basisplatte (2) angeordnet sind.

12. Kontaktierungsvorrichtung nach Anspruch 11, **dadurch gekennzeichnet**, daß im Übergangsbereich zwischen Kontaktfederarm (11) und Basisplatte (2) ein aus der Kante (3) seitlich vorspringendes Bogenstück (12) vorgesehen ist und die Kontaktfederarme (11) schräg aufeinanderzulaufend abgebogen sind, so daß ihre Querkanten (13) am freien Ende einen Steckkontaktschlitz (14) bilden.

13. Kontaktierungsvorrichtung nach einem oder mehreren der Ansprüche 10 bis 12, **dadurch gekennzeichnet**, daß die Breite eines Kontaktfederarms (11) etwa 1/3 der Länge einer Längskante (3) und die Länge eines Kontaktfederarms (11) etwa gleich der Länge eines Lötbeins (6) entspricht.

14. Kontaktierungsvorrichtung nach einem oder mehreren der Ansprüche 10 bis 13, **dadurch gekennzeichnet**, daß im Übergangsbereich einer Längskante in die Längskante (15) eines Kontaktfederarms (11) eine runde Ausnehmung (16) vorgesehen ist.

15. Kontaktierungsvorrichtung nach einem oder mehreren der Ansprüche 3 bis 14, **dadurch gekennzeichnet**, daß unter dem Steckkontaktschlitz (14) in der Basisplatte (2) ein rundes Loch (17) ausgestanzt ist.

16. Kontaktierungsvorrichtung nach Anspruch 15, **dadurch gekennzeichnet**, daß das Loch (17) mit nach oben zum Innenraum (18) zwischen den Kontaktfederarmen (11) geneigtem kegelstumpfförmigen bzw. kraterförmigen Trichterrand (19) ausgerüstet ist.

17. Kontaktierungsvorrichtung nach Anspruch 15 und/oder 16, **dadurch gekennzeichnet**, daß der Durchmesser des Lochs (17) etwas kleiner ist als die Breite eines Kontaktfederarms (11).

18. Kontaktierungsvorrichtung nach einem oder mehreren der Ansprüche 1 bis 17, **dadurch gekennzeichnet**, daß die Lötkontaktfeder (1) in eine Leiterplatte (20) gesteckt ist, die Steckschlitze (21) für die Lötbeine (6) aufweist, wobei die Steckschlitze (21) von den Lötbeinen (6) durchgriffen werden, so daß der Endbereich (8) der Lötbeine (6) nach unten herausragt.

19. Kontaktierungsvorrichtung nach Anspruch 18, **dadurch gekennzeichnet**, daß die gewölbten Lötbeine (6) mit Preßsitz in den Steckschlitzen (21) lagern, wobei sich die Wölbung an der entsprechenden Wandung und die Längskanten (7) in den entsprechenden Ecken eines Schlitzes abstützen.

20. Kontaktierungsvorrichtung nach Anspruch 18 und/oder 19, **dadurch gekennzeichnet**, daß sich der Stützsteg (5) auf der Oberfläche (22) der Leiterplatte (20) abstützt.

21. Kontaktierungsvorrichtung nach einem oder mehreren der Ansprüche 18 bis 20, **dadurch gekennzeichnet**, daß unter dem Loch (17) in der Leiterplatte (20) ein Loch (26) angeordnet ist.

22. Kontaktierungsvorrichtung nach Anspruch 21, **dadurch gekennzeichnet**, daß das Loch (26) den gleichen Durchmesser wie das Loch (27) aufweist.

23. Kontaktierungsvorrichtung nach einem oder mehreren der Ansprüche 20 bis 22, **dadurch gekennzeichnet**, daß die Lötbeine (6) an der Unterfläche (28) der Leiterplatte (20) über eine Lotmasse (29) mit einem Kontaktelement der Leiterplatte elektrisch in Verbindung stehen.

24. Kontaktierungsvorrichtung nach einem oder mehreren der Ansprüche 1 bis 23, **dadurch gekennzeichnet**, daß die Leiterdrähte (25,27) einer Leuchtdiode (23) von der Seite der Unterfläche (28) der Leiterplatte (20) jeweils durch ein Loch (26) der Leiterplatte und ein Loch (17) der Lötkontaktfeder (1) gesteckt sind und von den Federarmen (11) einer Lötkontaktfeder (1) elektrisch kontaktierend gehaltert werden.

25. Kontaktierungsvorrichtung nach einem oder mehreren der Ansprüche 1 bis 24, **dadurch gekennzeichnet**, daß die Endbereiche (11 a) der Kontaktfederarme (11) nach außen divergierend abgebogen sind.

26. Kontaktierungsvorrichtung nach Anspruch 25, **dadurch gekennzeichnet**, daß die Kontaktfederarme (11) derart aufeinanderzulaufend ausgebildet sind, daß sie sich im Steckschlitzbereich berühren und eine Kontaktlinie bilden.

FIG.1

FIG. 2

FIG. 4

FIG. 3

FIG. 5

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int Cl.) |
|---|---|---|---|
| A | US - A - 4 727 648 (SAVAGE) * Fig. 4,6,9,11,17; Spalte 5, Zeilen 21-62 * -- | 1-5, 18-26 | H 01 R 9/09 H 05 K 3/34 |
| A | US - A - 4 634 195 (SHOEMAKER) * Gesamt * -- | 1-7, 10,12, 18 | |
| A | DE - A1 - 2 746 273 (AMP) * Fig. 2; Seite 9, Zeile 4 - Seite 10, Zeile 27 * -- | 1-26 | |
| A | DE - A1 - 3 433 038 (LICENTIA) * Seite 5, Zeile 25 - Seite 6, Zeile 29 * ---- | 1-3 | |

| RECHERCHIERTE SACHGEBIETE (Int Cl.) |
|---|
| H 01 R 9/00 H 05 K 3/00 |

Der vorliegende Recherchenbericht wurde für alle Patentansprüche erstellt.

| Recherchenort | Abschlußdatum der Recherche | Prüfer |
|---|---|---|
| WIEN | 12-04-1990 | SCHMIDT |